(19) Europäisches Patentamt
European Patent Office
Office européen des brevets

(11) **EP 2 161 759 B1**

(12) **EUROPEAN PATENT SPECIFICATION**

(45) Date of publication and mention
of the grant of the patent:
**11.03.2015 Bulletin 2015/11**

(21) Application number: **08764876.2**

(22) Date of filing: **23.05.2008**

(51) Int Cl.:
**B32B 27/20** *(2006.01)*  **B32B 27/36** *(2006.01)*
**H01L 31/0216** *(2014.01)*  **H01L 31/0392** *(2006.01)*

(86) International application number:
**PCT/JP2008/059957**

(87) International publication number:
**WO 2008/146896 (04.12.2008 Gazette 2008/49)**

(54) **MULTILAYER FILM FOR SOLAR CELL BASE**

MEHRSCHICHTIGER FILM FÜR DIE BASIS EINER SOLARZELLE

FILM MULTICOUCHE POUR LA BASE D'UNE PILE SOLAIRE

(84) Designated Contracting States:
**AT BE BG CH CY CZ DE DK EE ES FI FR GB GR
HR HU IE IS IT LI LT LU LV MC MT NL NO PL PT
RO SE SI SK TR**

(30) Priority: **23.05.2007 JP 2007136489**

(43) Date of publication of application:
**10.03.2010 Bulletin 2010/10**

(73) Proprietor: **Teijin Dupont Films Japan Limited
Chiyoda-ku
Tokyo 100-0013 (JP)**

(72) Inventors:
  • **NISHIO, Rei
    Anpachi-gun
    Gifu 503-0123 (JP)**
  • **KUBO, Koji
    Anpachi-gun
    Gifu 503-0123 (JP)**

(74) Representative: **Cockerton, Bruce Roger et al
Carpmaels & Ransford LLP
One Southampton Row
London WC1B 5HA (GB)**

(56) References cited:
   JP-A- 02 181 975      JP-A- 07 263 727
   JP-A- 10 012 059      JP-A- 10 326 903
   JP-A- 2000 124 485    JP-A- 2007 048 659
   JP-A- 2008 091 162

• DATABASE WPI Week 199921 Thomson
  Scientific, London, GB; AN 1999-246686
  XP002654586, -& JP 2000 124485 A (SHARP KK)
  28 April 2000 (2000-04-28)
• DATABASE WPI Week 200829 Thomson
  Scientific, London, GB; AN 2008-E16140
  XP002654587, -& JP 2008 091162 A (DAINIPPON
  PRINTING CO LTD) 17 April 2008 (2008-04-17)

**Description**

TECHNICAL FIELD

The present invention relates to a multi-layer film for use as a solar cell substrate.

BACKGROUND OF THE ART

Solar cells are divided into rigid type solar cells comprising a glass substrate and flexible type solar cells comprising a plastic film substrate. Although the rigid type solar cells have higher energy conversion efficiency than the flexible type solar cells, there is a limit to the reductions of the thickness and weight of the device and further, it is conceivable that a solar cell module is damaged when it receives an impact. Therefore, attention is paid to the utility of the flexible type solar cells, and flexible type solar cells having various structures are proposed (for example, JP-A 1-198081, JP-A 2-260577, JP-B 6-5782 and JP-A 6-350117) and getting used as a power supply (mainly as an auxiliary power supply) for timepieces and mobile communication equipment such as mobile phones and portable terminals.

The above flexible type solar cells are mainly thin film type solar cells in which amorphous silicon or micro-crystal silicon is used in a generation layer (semiconductor layer) made as thin as several tens of $\mu$m or less, especially a few $\mu$m or less. The goal set for the thin film type solar cells is to increase the amount of light absorbed in the generation layer in order to improve photoelectric conversion efficiency. Attempts are being made to attain this goal by a so-called "light trapping effect" that the optical path of light in the generation layer is increased by forming an uneven conductive layer having a center line average surface roughness Ra of about 100 nm on the surface of a substrate so as to diffuse light.

However, to form the uneven conductive layer made of a metal or a metal oxide, a treatment at a temperature of 400°C or higher is required and therefore, it is difficult to form the layer on a flexible type solar cell comprising a plastic film substrate. In contrast to this, there is proposed a technology for materializing an uneven conductive layer by forming irregularities on a supporting layer from a resin composition containing a filler and then forming a conductive layer on the irregularities (JP-A 4-196364 and JP-A 1-119074). However, according to these methods, the concentration of the filler must be made high in order to obtain sufficiently effective irregularities, thereby impairing the strength of the substrate. Japanese Patent No. 3749015 discloses a technology in which a UV curable resin is applied to the surface of a supporting layer and pressed against a metal mold to be cured in order to form irregularities and then a conductive layer is formed on the irregularities. However, this method involves such problems that the process is complicated, thereby boosting costs, and that the residual solvent contained in a resin solution used to form the uneven layer is gasified and affects the formation of the conductive layer with the result that the shape formed by the uneven layer is not reflected in the conductive layer completely. JP-B 7-50794 discloses a technology for forming irregularities by using the above gas but it is difficult to control the amount of the residual solvent contained in the resin and the amount of the gas quantitatively, thereby making it extremely difficult to control the shape of the irregularities.

Further, since the generation layer is formed on the uneven conductive layer in all of the above technologies, the cell must be constituted such that the generation layer conforms with the irregularities so completely that it does not short-circuit, there is a limit to the reduction of the thickness of the solar cell, the degree of freedom of designing the generation layer is low, and also there is a limit to the improvement of photoelectric conversion efficiency.

JP 2000 124485 A discloses a photoelectric conversion device that contains a first electrode layer, a semiconductor photoelectric conversion layer and a second electrode layer, which are stacked on a substrate. A light diffusion layer for diffusing light is installed between the substrate and the first electrode layer. The light diffusion layer is formed by using resin having a surface texture containing fine projecting/recessing parts fitted for diffusing light and containing fine particles fitted for generating the surface texture.

DISCLOSURE OF THE INVENTION

It is an object of the present invention to provide a multi-layer film for use as a solar cell substrate which solves the above problems of the prior art and shows such a large light diffusion effect that a large "light trapping effect" can be obtained while the degree of freedom of designing a generation layer at the time of forming the layer is kept high.

That is, according to the present invention, the above object can be attained by a multi-layer film for use as a solar cell substrate, consisting of a supporting layer(s) and a scattering layer(s), wherein the supporting layer comprises a thermoplastic crystalline resin, the scattering layer comprises a thermoplastic crystalline resin and particles having a different refractive index from the refractive index of the thermoplastic crystalline resin, the content of the particles in the scattering layer is 0.05 to 20 vol% based on the volume of the scattering layer, the absolute value of the difference between the refractive index of the particles contained in the scattering layer and the refractive index of the thermoplastic crystalline resin in the scattering layer is 0.05 to 0.90, the both surfaces of the multi-layer film have a center line average surface roughness Ra of not more than 30 nm, and the multi-layer film has a total light transmittance Tt as measured in accordance with JIS K6714 of not less than 80 % and

a haze ratio as measured in accordance with JIS K6714 of not less than 8 %, wherein the refractive index of the thermoplastic crystalline resin is the average value of the refractive index nMD in the film forming direction within the plane of the film and the refractive index nTD in a direction perpendicular to the film forming direction within the plane of the film, at a wavelength of 633 nm, wherein vol% is a value calculated from the true density of the particles and the density of the resin in an amorphous state obtained from the content (wt%) of the particles in the scattering layer, and wherein the center line average surface roughness Ra is calculated from equation (1)

$$Ra = 1 \diagup (LXLY) \int_{0}^{LX} \int_{0}^{LY} |f(X, Y)| dXdY \qquad (1)$$

wherein a roughness curve is represented by Z = F(X,Y) and is obtained by measuring a projection profile of the surface of the film with an optical probe having a beam diameter of 1.6 $\mu$m of a semiconductor laser having a wavelength of 780 nm by using a non contact 3-D roughness meter under the following conditions: measurement length (LX) of 1 mm, sampling pitch of 2 $\mu$m, cut-off of 0.25 mm, magnification in the longitudinal direction of 5,000X, magnification in the traverse direction of 200X and 100 scanning lines.

The above haze ratio is the ratio of a diffuse component to the total light transmittance of the film.

BEST MODE FOR CARRYING OUT THE INVENTION

The present invention will be described in detail hereinunder.

Supporting layer

The supporting layer of the multi-layer film for use as a solar cell substrate of the present invention comprises a thermoplastic crystalline resin. Since the thermoplastic crystalline resin can be molded by melt extrusion and has excellent heat resistance, it is preferably used in the manufacture of a solar cell. The thermoplastic crystalline resin is selected from a polyether ether ketone, polyphenylene sulfide, polyamide and polyester. Out of these, a polyester which has a low water absorption coefficient and relatively high gas barrier properties is preferred from the viewpoints of the process and the durability of a final product. Examples of the polyester include a polyester comprising an ethylene terephthalate component as the main recurring unit and a polyester comprising an ethylene 2,6-naphthalene dicarboxylate component as the main recurring unit. The content of the ethylene terephthalate component in the polyester comprising an ethylene terephthalate component as the main recurring unit used in the supporting layer is preferably 80 to 100mol%, more preferably 90 to 100 mol% based on the total of all the recurring units of the polyester. Examples of the comonomer in this case include isophthalic acid and 2,6-naphthalenedicarboxylic acid. The content of the ethylene-2,6-naphthalene dicarboxylate component in the polyester comprising an ethylene-2,6-naphthalene dicarboxylate component as the main recurring unit used in the supporting layer is preferably 80 to 100 mol%, more preferably 90 to 100 mol% based on the total of all the recurring units of the polyester. Examples of the comonomer in this case include terephthalic acid and isophthalic acid.

Out of these thermoplastic crystalline resins, the polyester comprising an ethylene-2,6-naphthalene dicarboxylate component as the main recurring unit is preferred from the viewpoint of obtaining high dimensional stability.

Scattering layer

The scattering layer of the multi-layer film for use as a solar cell substrate of the present invention comprises a thermoplastic crystalline resin and particles having a refractive index different from the refractive index of the thermoplastic crystalline resin.

The thermoplastic crystalline resin is preferably a resin having high heat resistance such as polyether ether ketone, polyphenylene sulfide, polyamide or polyester in consideration of the step of processing it into a solar cell. Out of these, a polyester which has a low water absorption coefficient and relatively high gas barrier properties is preferred from the viewpoints of the process and the durability of a final product. Examples of the polyester include a polyester comprising an ethylene terephthalate component as the main recurring unit and a polyester comprising an ethylene-2,6-naphthalene dicarboxylate component as the main recurring unit. The content of the ethylene terephthalate component in the polyester comprising an ethylene terephthalate component as the main recurring unit used in the scattering layer is preferably 65 to 100 mol%, more preferably 70 to 100 mol%, much more preferably 80 to 100 mol%, particularly preferably 90 to 100 mol% based on the total of all the recurring units of the polyester. Examples of the comonomer in this case include isophthalic acid and 2,6-naphthalenedicarboxylic acid. The content of the ethylene-2,6-naphthalene dicarboxylate component in the polyester comprising an ethylene-2,6-naphthalene dicarboxylate component as the main recurring unit used in the scattering layer is preferably 65 to 100 mol%, more preferably 70 to 100 mol%, much more preferably 80 to 100 mol%, particularly preferably 90 to 100 mol% based on the total of all the recurring units of the polyester. Examples of the comonomer in this case include terephthalic acid and isophthalic acid.

Out of these thermoplastic crystalline resins, the polyester comprising an ethylene-2,6-naphthalene dicarboxylate component as the main recurring unit is preferred from the viewpoint of obtaining high dimensional stability.

The thermoplastic crystalline resin of the scattering layer may be the same or different from the thermoplastic crystalline resin of the supporting layer. A multi-layer film consisting of a supporting layer comprising polyethylene-2,6-naphthalene dicarboxylate and a scattering layer comprising particles and polyethylene-2,6-naphthalene dicarboxylate is particularly preferred because its heat shrinkage factor at a high temperature, for example, its heat shrinkage factor when it is heated at 200°C for 10 minutes is low.

The shape of the particles in the scattering layer is spherical, steric, tetrapod-like, lamellar or rod-like. The average particle diameter of the particles is preferably 0.05 to 10 $\mu$m, more preferably 0.1 to 8 $\mu$m, particularly preferably 0.2 to 6 $\mu$m. When the average particle diameter of the particles is smaller than 0.05 $\mu$m, the scattering layer cannot diffuse light completely and when the average particle diameter is larger than 10 $\mu$m, it may be difficult to maintain a sufficiently high light transmittance. The average particle diameter of the particles is a particle diameter at a 50 wt% point read from an integration curve of the particles of each particle diameter and the amount thereof calculated from a centrifugal sedimentation curve obtained from measurements with the CP-50 Centrifugal Particle Size Analyzer of Shimadzu Corporation. This average particle diameter is a value read as a sphere equivalent diameter when the particles are not spherical.

The refractive index of the particles is preferably 1.20 to 2.50. In the present invention, a light scattering effect is obtained by a refractive index difference between the thermoplastic crystalline resin and the particles in the scattering layer. The refractive index of the thermoplastic crystalline resin is the average value of the in-plane refractive index of a film of the thermoplastic crystalline resin. For example, when the thermoplastic crystalline resin film is produced by melt extrusion, the refractive index of the thermoplastic crystalline resin is the average value of the refractive index nMD in the film forming direction within the plane of the film and the refractive index nTD in a direction perpendicular to the film forming direction within the plane of the film. When the multi-layer film is a stretched film, the refractive index of the thermoplastic crystalline resin is the refractive index of a stretched film of the thermoplastic crystalline resin.

As the difference between the refractive index of the thermoplastic crystalline resin and the refractive index of the particles in the scattering layer becomes larger, the light scattering effect is obtained more easily. However, when the refractive index difference is too large, the light transmittance may degrade. To obtain both the light scattering effect and the light transmission properties, the absolute value of the difference between the refractive index of the particles and the refractive index of the thermoplastic crystalline resin in the scattering layer is 0.05 to 0.90, preferably 0.10 to 0.50.

When polyethylene-2,6-naphthalene dicarboxylate is used as the thermoplastic crystalline resin of the scattering layer and its refractive index is, for example, 1.75, the refractive index of the particles is preferably in the range of 1.10 to 1.70 or 1.80 to 2.20 in order to obtain both the light scattering effect and the light transmission properties. Examples of the particles include inorganic particles, organic particles, silicone resin particles and organic salt particles. Examples of the material of the inorganic particles include silica, calcium carbonate, alumina, titanium dioxide, zeolite, kaolin clay, composites thereof and barium sulfate. The above composites include composite oxides and core-shell type composites. The organic particles are preferably crosslinked polymer particles such as crosslinked polystyrene particles or melamine resin particles. Examples of the material of the organic salt particles include clathrate compounds and complex compounds containing a metal atom, and examples of the metal atom include silver, copper and iron. In this case, the content of the particles in the scattering layer is preferably 0.05 to 20 vol%, more preferably 0.1 to 15 vol%. "vol%" is a value calculated from the true density of the particles and the density of the resin in an amorphous state obtained from the content (wt%) of the particles in the scattering layer. When the content of the particles is lower than 0.05 vol%, light cannot be scattered completely and when the content is higher than 20 vol%, a layer of this resin becomes fragile, whereby practical mechanical strength may not be obtained disadvantageously. The particles used herein may be a single type of particles or two or more different types of particles. In either case, particles having different particle diameters may be used in combination.

When polyphenylene sulfide is used as the thermoplastic crystalline resin of the scattering layer and its refractive index is, for example, 1.77, the refractive index of the particles is preferably in the range of 1.12 to 1.72 or 1.82 to 2.52 to obtain both the light scattering effect and the light transmission properties. The particles in this case are selected from inorganic particles, organic particles, organic salt particles and fluororesin particles. As for the materials constituting the inorganic particles, organic particles and organic salt particles, the same materials as those for the above inorganic particles, organic particles and organic salt particles which are preferably used when the thermoplastic crystalline resin of the scattering layer is polyethylene-2,6-naphthalene dicarboxylate may be used likewise. In this case, the content of the particles in the scattering layer is preferably 0.01 to 20 vol%, more preferably 0.1 to 15 vol%.

When a polyamide is used as the thermoplastic crystalline resin of the scattering layer and the polyamide is nylon having a refractive index of 1.54, the refractive index of the particles is preferably in the range of 1.09 to 1.49 or 1.59 to 2.21 in order to obtain both the light scattering effect and the light transmission properties. The particles are selected from inorganic particles, organic particles, organic salt particles and fluororesin particles. As for the materials constituting the inorganic particles, organic particles and organic salt particles, the same materials as those for the above inorganic particles, organic particles and organic salt particles which are preferably used when the thermoplastic crystalline resin of the scattering layer is polyethylene-2,6-naphthalene dicarboxylate may be used likewise. In this case, the content of the particles in the scattering layer is preferably 0.01 to 20 vol%, more preferably 0.1 to 18 vol%.

Additives

Additives may be added to one or both of the thermoplastic crystalline resins of the supporting layer and the scattering layer. The additives which may be added include an ultraviolet absorbent, antioxidant, heat stabilizer, lubricant (for example, wax), flame retardant and antistatic agent.

The above ultraviolet absorbent is preferably added to the thermoplastic crystalline resins to further improve the weatherability of the multi-layer film. The ultraviolet absorbent is preferably a compound which has a large light absorption coefficient and is effective even with a small amount, such as 2,2'-p-phenylenebis(3,1-benzoxazin-4-one), 2,2'-(4,4'-diphenylene)bis(3,1-benzoxazin-4-one) or 2,2'-(2,6-naphthylene)bis(3,1-benzoxazin-4-one). When an ultraviolet absorbent is added, the amount thereof is, for example, 0.01 to 10 wt% based on the weight of the multi-layer film.

Constitution of multi-layer film for use as a solar cell substrate

The multi-layer film for use as a solar cell substrate of the present invention consists of the above supporting layer (s) and the above scattering layer (s). The multi-layer film may be a double-layer film consisting of one supporting layer and one scattering layer or a multi-layer film comprising two or more supporting layers and/or two or more scattering layers. When the film consists of three or more layers, the supporting layer is preferably arranged as the outermost layer on one side. Particularly preferably, the film is a double-layer film consisting of one supporting layer and one scattering layer or a three-layer film consisting of a supporting layer, a scattering layer and a supporting layer in this order.

The thickness of the multi-layer film for use as a solar cell substrate of the present invention is preferably 15 to 250 $\mu$m, more preferably 50 to 200 $\mu$m, particularly preferably 60 to 125 $\mu$m. When the thickness is smaller than 15 $\mu$m, the stiffness of the film as a substrate for a solar cell becomes small, whereby the film may not be able to support the solar cell disadvantageously. When the thickness is larger than 250 $\mu$m, a solar cell module becomes too thick, whereby flexibility may be lost disadvantageously.

In order to enhance the total light transmittance of the multi-layer film, the content of the particles in the supporting layer should be made as low as possible within the above preferred range and the thickness ratio (the ratio of the thickness of the supporting layer to the thickness of the scattering layer) should be made large. The scattering layer also needs a certain measure of thickness to enhance its light scattering effect. The thickness ratio of the multi-layer film which has a double-layer structure consisting of one supporting layer and one scattering layer is preferably 0.1 to 30, more preferably 1 to 30, much more preferably 3 to 20, particularly preferably 5 to 15. When the multi-layer film has two or more supporting layers and/or two or more scattering layers, the ratio of the total thickness of the supporting layers to the total thickness of the scattering layers is preferably 1 to 30, more preferably 1.5 to 20, particularly preferably 2 to 15.

Center average surface roughness

The both surfaces of the multi-layer film for use as a solar cell substrate of the present invention have a center line average surface roughness Ra of not more than 30 nm.

When the multi-layer film has a double-layer structure consisting of one supporting layer and one scattering layer, the center line average surface roughness Ra of the supporting layer side surface of the multi-layer film is not more than 30 nm and the center line average surface roughness Ra of the scattering layer side surface is not more than 30 nm. When the multi-layer film is a three-layer film consisting of a supporting layer, a scattering layer and a supporting layer in this order, the both surfaces of the multi-layer film again have a center line average surface roughness Ra of not more than 30 nm.

In either case, the both surfaces of the multi-layer film have a center line average surface roughness Ra of not more than 30 nm, preferably not more than 10 nm. When the center line average surface roughness Ra of each surface of the multi-layer film exceeds 50 nm, the thickness and shape of the generation layer are limited so as to suppress a short-circuit, thereby reducing the degree of layer design freedom for improving the photoelectric conversion efficiency of the generation layer disadvantageously.

Optical properties

The multi-layer film for use as a solar cell substrate of the present invention has a total light transmittance Tt of not less than 80 %, preferably 80 to 100 %. The haze ratio which is the ratio of a diffuse component to the total light transmittance Tt of the multi-layer film is not less than 8 %, preferably 8 to 100 %, more preferably 15 to 100 %.

When the total light transmittance is less than 80 %, the amount of light incident on the solar cell decreases, thereby making it impossible to obtain high power generation efficiency. When the haze ratio is less than 8 %, light diffusion is little and a satisfactory light trapping effect cannot be obtained.

The above optical properties can be achieved by forming the supporting layer from a thermoplastic crystalline resin and the scattering layer from a thermoplastic crystalline resin and particles having a refractive index different from the refractive index of the thermoplastic crystalline resin, setting the content of the particles in the scattering layer to 0.05 to 20 vol% based on the volume of the scattering layer, and setting the absolute value of the difference between the refractive index of the particles contained in the scattering layer and the refractive index of the thermoplastic crystalline resin in the scattering layer to 0.05 to 0.90.

Heat shrinkage factor

The multi-layer film for use as a solar cell substrate of the present invention has a heat shrinkage factor of preferably not more than 1 %, more preferably not more than 0.8 %, particularly preferably not more than 0.6 % when it is heated at 200°C for 10 minutes in order to suppress a dimensional change in the heating step in the solar cell production process. This heat shrinkage factor can be achieved by using a polyester comprising an ethylene-2,6-naphthalene dicarboxylate component as the main recurring unit, preferably a polyester comprising 90 to 100 mol% of an ethylene-2,6-naphthalene dicarboxylate component based on the total of all the recurring units in the polyester as the supporting layer.

Method of producing the multi-layer film

The multi-layer film for use as a solar cell substrate of the present invention is preferably produced by melting a thermoplastic crystalline resin which will constitute the supporting layer and a composition comprising a thermoplastic crystalline resin and particles, which will constitute the scattering layer, melt extruding these by a coextrusion method and stretching them. When the film is produced by a solution method, a gas derived from the residual solvent is generated in the step of forming a conductive layer on the film or the step of forming an optical generation layer to cause a trouble in the depressurizing step or remains as an impurity disadvantageously in the post-step for processing the film into a solar cell.

As the method of producing a multi-layer film, one in which resins extruded from different extruders are joined together by a feed block and extruded from a die and one in which resins extruded from different extruders are joined together in a die right before extrusion and extruded from a multi-manifold die may be employed.

To obtain mechanical strength sufficiently high for practical use when the particles are added to the scattering layer in a high concentration, the multi-layer film is preferably produced by biaxial orientation.

The method of producing the multi-layer film when a polyester is used as the thermoplastic crystalline resin will be described in detail hereinunder. In this example, an unstretched multi-layer film is obtained by coextrusion and then a biaxially oriented multi-layer film is obtained by sequential biaxial orientation.

The thermoplastic crystalline resin which will constitute the supporting layer and the composition comprising the thermoplastic crystalline resin and the particles, which will constitute the scattering layer, are heated under normal pressure or dried under a reduced pressure to remove water as required, molten at a melt extrusion temperature which is generally used in the industry, that is, a temperature of its melting point (to be represented by "Tm" hereinafter) to (Tm+50°C) in different extruders, formed into two layers by using a feed block, extruded from a die slit and solidified by quenching on a rotary cooling drum cooled to a glass transition temperature (to be expressed as Tg hereinafter) of a resin having the lowest Tg out of the resins of the layers or lower to obtain an amorphous sheet. The obtained sheet was stretched to 2.5 to 4.5 times in the longitudinal direction at a temperature of Tg of the resin having the highest Tg out of the resins of the layers to (Tg+50°C) and then to 2.5 to 4.5 times in the transverse direction at a temperature of Tg of the resin having the highest Tg out of the resins of the layers to (Tg+50°C). Simultaneous biaxial stretching in which longitudinal stretching and transverse stretching are carried out at the same time is preferred because it is easy to balance mechanical properties in the longitudinal direction and the transverse direction.

The film which has been stretched in the longitudinal direction and the transverse direction is heat set at a crystallization temperature (to be expressed as "Tc" hereinafter) of a resin having the lowest Tc out of the resins of the layers to (Tm-20°C) of a resin having the highest Tm out of the resins of the layers. Thereafter, the biaxially oriented film is preferably relaxed at a relaxation ratio of 0.5 to 15 % in one or both of the longitudinal and transverse directions to further reduce its heat shrinkage factor. The thermal relaxation may be carried out in another step after winding, besides at the time of producing a film. When the thermal relaxation is carried out after winding, the film is thermally relaxed while it is suspended as disclosed by JP-A 1-275031.

Solar cell

The multi-layer film for use as a solar cell substrate of the present invention can be advantageously used as a substrate for solar cells. Especially when it is used as a substrate for flexible type thin film solar cells, the advantageous effect of the present invention is maximized.

Since the multi-layer film for use as a solar cell substrate of the present invention has extremely smooth surfaces on both sides with a center line average surface roughness Ra of not more than 30 nm, the degree of freedom of designing the generation layer becomes high, thereby contributing to the reduction of the thickness and the improvement of the photoelectric conversion efficiency of a solar cell.

When the both surfaces of the multi-layer film differ from each other in center line average surface roughness Ra, the generation layer is preferably arranged on a side having a smaller center line averages surface roughness Ra because the degree of freedom of designing the generation layer becomes higher. For example, when the multi-layer film has a double-layer structure consisting of one supporting layer and one scattering layer, the generation layer is preferably arranged on the supporting layer side.

Examples

The following examples are given to further illustrate the present invention.

Characteristic property values were measured by the following methods.

(1) Intrinsic viscosity

The viscosity of an orthochlorophenol solvent solution was measured at 35°C.

(2) Thickness of each layer

A film sample was cut into a triangle which was fixed in a capsule and embedded in an epoxy resin. The embedded sample was sliced in the longitudinal direction with a microtome (ULTRACUT-S of Reichert-Jung AG) to obtain a 50 nm-thin piece which was observed and photomicrographed by a transmission electron microscope at an acceleration voltage of 100 kV to measure the thickness of each layer from the obtained photomicrograph. (3) Heat shrinkage factor

The film was kept in an oven set to 200°C under no tension for 10 minutes to measure the gauge length $L_0$ before the heat treatment and the gauge length L after the heat treatment and calculate its dimensional change rate as heat shrinkage factor S (%) from the following equation.

$$S = ((L_0-L)/L_0) \times 100$$

The gauge length was obtained by measuring the distance between two gauge points marked at intervals of about 300 mm to the unit of 0.1 mm.

(4) Average particle diameter of particles

The particle diameter at a 50 wt% point was read from an integration curve of the particles of each particle diameter and the amount thereof calculated from a centrifugal sedimentation curve obtained from measurements with the CP-50 Centrifugal Particle Size Analyzer of Shimadzu Corporation.

(5) Center line average surface roughness (Ra)

The projection profile of the surfaces of the film was measured with an optical probe having a beam diameter of 1.6 $\mu$m of a semiconductor laser having a wavelength of 780 nm by using a non-contact 3-D roughness meter (ET30HK of Kosaka Laboratory Ltd.) under the following conditions: measurement length (LX) of 1 mm, sampling pitch of 2 $\mu$m, cut-off of 0.25 mm, magnification in the longitudinal direction of 5,000X, magnification in the transverse direction of 200X and 100 scanning lines (therefore, the measurement length LY in the Y direction was 0.2 mm). When the roughness curve was represented by Z = F (X, Y), the value (Ra, unit: nm) obtained from the following equation was taken as the center line surface roughness (Ra) of the film.

$$Ra = 1/(LXLY) \int_0^{LX} \int_0^{LY} |f(X, Y)| dX dY$$

(6) Total light transmittance (Tt) of multi-layer film

The total light transmittance Tt (%) was measured in accordance with JIS K6714.

(7) Haze ratio (ratio of a diffuse component to the total light transmittance of multi-layer film)

The haze ratio of the multi-layer film was measured by using the NDH-2000 haze meter of Nippon Denshoku Industries Co., Ltd.) in accordance with JIS K6714. When the front and rear surfaces of the multi-layer film differ from each other in center line average surface roughness Ra, the surface having a higher center line surface roughness (Ra) of the multi-layer film was measured.

As the haze ratio of the multi-layer film becomes higher, the light scattering efficiency of the multi-layer film for use as a solar cell substrate increases.

(8) Refractive index

The refractive index of the thermoplastic crystalline resin is the average value of the refractive index nMD in the film forming direction within the plane of the film and the refractive index nTD in a direction perpendicular to the film forming direction within the plane of the film, out of the refractive indices in all the directions obtained by measuring a thermoplastic crystalline resin film molded by melt extrusion at a wavelength of 633 nm with the Prism Coupler of Metricon Corporation.

Example 1

Polyethylene-2,6-naphthalene dicarboxylate (amorphous density of 1.33, intrinsic viscosity of 0.65) as the thermoplastic crystalline resin which would become a supporting layer and polyethylene-2,6-naphthalene dicarboxylate (amorphous density of 1.33, intrinsic viscosity of 0.65, refractive index of 1.76) containing 0.1 vol% of spherical silica having an average particle diameter of 0.3 $\mu$m (Seahostar KEP-30 of Nippon Shokubai Co., Ltd., true density of 2.0, refractive index of 1.43 (values in the catalog)) which was a composition for forming a scattering layer were dried at 170°C for 6 hours separately and supplied into different extruders.

They were molten at 305°C and joined together by using a feed block to form a three-layer structure consisting of a supporting layer, a scattering layer and a supporting layer in this order, and the structure was extruded from a slit die and solidified by quenching on a rotary cooling drum whose surface temperature was kept at 50 ° C to obtain an unstretched film.

This unstretched film was then stretched to 3.1 times in the longitudinal direction at 140°C and then to 3.3 times in the transverse direction at 145°C, further heat set at 245°C for 5 seconds and shrunk by 2 % in the width direction to obtain a multi-layer film for use as a solar cell substrate having a thickness of 50 $\mu$m and a three-layer structure. The thickness of the supporting layer of the obtained multi-layer film was 10 $\mu$m, the thickness of the scattering layer was 30 $\mu$m, the center line average surface roughness Ra of the front surface of the scattering layer was 1.2 nm, the total light transmittance Tt of the film was 84 %, and the haze ratio (the ratio of a diffuse component to the total light transmittance of the film) was 8.3 %. The heat shrinkage factor of this multi-layer film was 0.5 %.

Examples 2 and 3

Multi-layer films for use as a solar cell substrate were produced in the same manner as in Example 1 except that the thickness of the supporting layer, the thickness of the scattering layer and the content of the particles in the scattering layer were changed as shown in Tables 1 and 2. The characteristic properties of the obtained multi-layer films are shown in Table 3. All the multi-layer films had high light diffusion efficiency, a center line average surface roughness Ra of not more than 30 nm and a heat shrinkage factor of 0.6 %.

Example 4

A multi-layer film for use as a solar cell substrate was produced in the same manner as in Example 1 except that 2 parts by weight of 2,6-naphthalenebis(1,3-benzoxazin-4-one) as an ultraviolet absorbent was added to 100 parts by weight of the resin of the supporting layer. The characteristic properties of the obtained multi-layer film are shown in Table 3. The multi-layer film had high light diffusion efficiency, a center line average surface roughness Ra of not more than 30 nm and a heat shrinkage factor of 0.6 %.

Example 5

A multi-layer film for use as a solar cell substrate was produced in the same manner as in Example 1 except that the multi-layer film had a double-layer structure consisting of one supporting layer and one scattering layer. The characteristic properties of the obtained multi-layer film are shown in Table 3. The multi-layer film had high light diffusion efficiency, a center line average surface roughness Ra of not more than 30 nm and a heat shrinkage factor of 0.5 %.

Examples 6 to 8

Multi-layer films for use as a solar cell substrate were produced in the same manner as in Example 1 except that the type and content of the particles contained in the scattering layer and the thickness of the scattering layer were changed as shown in Table 1. The characteristic properties of the obtained multi-layer films are shown in Table 2. All the multi-layer films had high light diffusion efficiency, a center line average surface roughness Ra of not more than 30 nm and a heat shrinkage factor of 0.6 %.

Examples 9 to 11

Multi-layer films for use as a solar cell substrate were produced in the same manner as in Example 6 except that the type of the thermoplastic crystalline resin used in the scattering layer was changed as shown in Table 1. The characteristic properties of the obtained multi-layer films are shown in Table 2. All the multi-layer films had high light diffusion efficiency, a center line average surface roughness Ra of not more than 30 nm and a heat shrinkage factor of 0.7 % in Example 9 and 1.0 % in Examples 10 and 11.

Comparative Example 1

A film was produced in the same manner as in Example 1 except that no particles were added to the composition which would constitute the scattering layer. The characteristic properties of the film are shown in Table 2. The film had low light diffusion efficiency.

Comparative Example 2

A film was produced in the same manner as in Example 9 except that no particles were added to the composition which would constitute the scattering layer. The characteristic properties of the film are shown in Table 2. The film had low light diffusion efficiency.

Table 1

| | Scattering layer | | | | | | | Thickness of scattering layer (μm) |
| | Particles | | | | | Thermoplastic crystalline resin | | |
| | Type of particles | Density (g/cm³) | Refractive index | Average particle diameter (μm) | Content (vol%) | Type | Refractive index | |
|---|---|---|---|---|---|---|---|---|
| Ex.1 | Silica | 2 | 1.43 | 0.3 | 0.1 | PEN | 1.76 | 30 |
| Ex.2 | Silica | 2 | 1.43 | 0.3 | 0.2 | PEN | 1.75 | 30 |
| Ex.3 | Silica | 2 | 1.43 | 0.3 | 0.3 | PEN | 1.75 | 20 |
| Ex.4 | Silica | 2 | 1.43 | 0.3 | 0.1 | PEN | 1.76 | 30 |
| Ex.5 | Silica | 2 | 1.43 | 0.3 | 0.1 | PEN | 1.75 | 30 |
| Ex.6 | Melamine resin 1 | 1.4 | 1.66 | 3 | 1 | PEN | 1.75 | 10 |
| Ex.7 | Melamine resin 2 | 1.4 | 1.66 | 5 | 1 | PEN | 1.75 | 10 |
| Ex.8 | Melamine resin 3 | 1.5 | 1.66 | 1.5 | 0.9 | PEN | 1.75 | 10 |
| Ex.9 | Melamine resin 3 | 1.5 | 1.66 | 1.5 | 0.9 | 8MTA co-PEN | 1.74 | 10 |
| Ex.10 | Melamine resin 3 | 1.5 | 1.66 | 1.5 | 0.9 | 18.5MTA co-PEN | 1.72 | 10 |
| Ex.11 | Melamine resin 3 | 1.5 | 1.66 | 1.5 | 0.9 | 30MTA co-PEN | 1.70 | 10 |
| C. Ex.1 | - | - | - | - | - | PEN | 1.76 | - |
| C. Ex.2 | - | - | - | - | - | 30MTA co-PEN | 1.70 | - |
| Ex.: Example C.Ex.: Comparative Example | | | | | | | | |

EP 2 161 759 B1

Table 2

| | Supporting layer | | Total thickness of film (μm) | Layer constitution |
|---|---|---|---|---|
| | Type of thermoplastic crystalline resin | Thickness of support layer (μm) | | |
| Ex.1 | PEN | 10 | 50 | Three layers (core: scattering layer) |
| Ex.2 | PEN | 10 | 50 | Three layers (core: scattering layer) |
| Ex.3 | PEN | 15 | 50 | Three layers (core: scattering layer) |
| Ex.4 | PEN | 10 | 50 | Three layers (core: scattering layer) |
| Ex.5 | PEN | 20 | 50 | Two layers |
| Ex.6 | PEN | 45 | 100 | Three layers (core: scattering layer) |
| Ex.7 | PEN | 45 | 100 | Three layers (core: scattering layer) |
| Ex.8 | PEN | 45 | 100 | Three layers (core: scattering layer) |
| Ex.9 | PEN | 30 | 70 | Three layers (core: scattering layer) |
| Ex.10 | PEN | 30 | 70 | Three layers (core: scattering layer) |
| Ex.11 | PEN | 30 | 70 | Three layers (core: scattering layer) |
| C. Ex.1 | PEN | - | 50 | Three layers (core: scattering layer) |
| C. Ex.2 | 30MTA co-PEN | - | 50 | Three layers (core: scattering layer) |
| Ex.: Example C.Ex.: Comparative Example | | | | |

Table 3

| | Total light transmittance Tt (%) | Haze ratio (%) | Center line average surface roughness Ra front surface (nm) / rear surface (nm) | Heat shrinkage factor (%) |
|---|---|---|---|---|
| Vex.1 | 84.4 | 8.3 | 1.6/1.3 | 0.5 |
| Ex.2 | 83.5 | 12.6 | 2.2/2.1 | 0.6 |
| Ex.3 | 82.8 | 16.3 | 1.3/1.4 | 0.6 |
| Ex.4 | 83.3 | 9.0 | 1.7/1.8 | 0.6 |
| Ex.5 | 84.8 | 9.1 | 1.7/13.1 | 0.5 |
| Ex.6 | 81.2 | 31 | 6.5/6.8 | 0.6 |
| Ex.7 | 82.4 | 25.9 | 9.5/9.2 | 0.6 |
| Ex.8 | 81.7 | 38.5 | 3.2/3.1 | 0.6 |

(continued)

|  | Total light transmittance Tt (%) | Haze ratio (%) | Center line average surface roughness Ra front surface (nm) / rear surface (nm) | Heat shrinkage factor (%) |
|---|---|---|---|---|
| Ex.9 | 82.9 | 41.5 | 3.1/3.2 | 0.7 |
| Ex.10 | 84.3 | 36.5 | 3.2/3.3 | 1.0 |
| Ex.11 | 85.1 | 33.8 | 2.9/3.0 | 1.0 |
| C. Ex.1 | 85.8 | 0.2 | 0.7/0.8 | 0.5 |
| C. Ex.2 | 86.9 | 1.8 | 1.2/1.9 | 1.0 |
| Ex.: Example C.Ex.: Comparative Example | | | | |

The abbreviations of the particles and the thermoplastic crystalline resins in the above tables denote the following.

Particles

Silica: Seahostar KEP-30 of Nippon Shokubai Co., Ltd.
Melamine resin 1: Epostar M30 of Nippon Shokubai Co., Ltd.
Melamine resin 2: Epostar M05 of Nippon Shokubai Co., Ltd.
Melamine resin 3: Epostar S12 of Nippon Shokubai Co., Ltd.

Thermoplastic crystalline resin

PEN: polyethylene-2,6-naphthalene dicarboxylate 8MTA co-PEN: polyethylene-2,6-naphthalene dicarboxylate/polyethylene terephthalate copolymer containing 8 mol% of a terephthalate component 18.5MTA co-PEN: polyethylene-2,6-naphthalene dicarboxylate/polyethylene terephthalate copolymer containing 18.5 mol% of a terephthalate component 30MTA co-PEN: polyethylene-2,6-naphthalene dicarboxylate/polyethylene terephthalate copolymer containing 30 mol% of a terephthalate component
In the double-layer film of Example 5, the supporting layer side was made the front side.

Effect of the Invention

According to the present invention, there is provided a multi-layer film for use as a solar cell substrate which shows such a large light diffusion effect that a large "light trapping effect" can be obtained while the degree of freedom of designing a generation layer at the time of forming the layer is kept high.

**Claims**

1. A multi-layer film for use as a solar cell substrate, consisting of a supporting layer(s) and a scattering layer(s), wherein the supporting layer comprises a thermoplastic crystalline resin, the scattering layer comprises a thermoplastic crystalline resin and particles having a different refractive index from the refractive index of the thermoplastic crystalline resin, the content of the particles in the scattering layer is 0.05 to 20 vol% based on the volume of the scattering layer, the absolute value of the difference between the refractive index of the particles contained in the scattering layer and the refractive index of the thermoplastic crystalline resin in the scattering layer is 0.05 to 0.90, the both surfaces of the multi-layer film have a center line average surface roughness Ra of not more than 30 nm, and the multi-layer film has a total light transmittance Tt as measured in accordance with JIS K6714 of not less than 80 % and a haze ratio as measured in accordance with JIS K6714 of not less than 8 %,
wherein the refractive index of the thermoplastic crystalline resin is the average value of the refractive index $n_{MD}$ in the film forming direction within the plane of the film and the refractive index $n_{TD}$ in a direction perpendicular to the film forming direction within the plane of the film, at a wavelength of 633 nm,
wherein vol % is a value calculated from the true density of the particles and the density of the resin in an amorphous state obtained from the content (wt%) of the particles in the scattering layer, and

wherein the center line average surface roughness Ra is calculated from equation (1)

$$Ra = 1/(LXLY) \int_0^{LX} \int_0^{LY} |f(X, Y)| dXdY \tag{1}$$

wherein a roughness curve is represented by Z = F(X, Y) and is obtained by measuring a projection profile of the surface of the film with an optical probe having a beam diameter of 1.6 $\mu$m of a semiconductor laser having a wavelength of 780 nm by using a non-contact 3-D roughness meter under the following conditions: measurement length (LX) of 1 mm, sampling pitch of 2 $\mu$m, cut-off of 0.25 mm, magnification in the longitudinal direction of 5,000X, magnification in the transverse direction of 200X and 100 scanning lines.

2. The multi-layer film for use as a solar cell substrate according to claim 1, wherein the thermoplastic crystalline resins of the supporting layer and the scattering layer are a thermoplastic polyester.

3. The multi-layer film for use as a solar cell substrate according to claim 2, wherein the thermoplastic polyester of the supporting layer and the scattering layer is a polyester comprising an ethylene-2,6-naphthalene dicarboxylate component as the main recurring unit.

4. The multi-layer film for use as a solar cell substrate according to claim 3, wherein the particles are silica particles or melamine resin particles.

5. The multi-layer film for use as a solar cell substrate according to any one of claims 1 to 4, wherein the multi-layer film has a three-layer structure consisting of a supporting layer, a scattering layer and a supporting layer in this order.

6. A use of a multi-layer film as a substrate for a solar cell, wherein the solar cell is a flexible type thin film solar cell and wherein the multi-layer film is as defined in any of claims 1 to 4.

**Patentansprüche**

1. Mehrschichtiger Film für die Verwendung als Solarzellensubstrat, bestehend aus einer Trägerschicht/Trägerschichten und einer Streuungsschicht/Streuungsschichten, wobei
die Trägerschicht ein thermoplastisches kristallines Harz umfasst, die Streuungsschicht ein thermoplastisches kristallines Harz und Partikel mit einem Brechungsindex, der von dem Brechungsindex des thermoplastischen kristallinen Harz verschieden ist, umfasst, wobei der Gehalt an den Partikeln in der Streuungsschicht 0,05 bis 20 Vol.-% bezogen auf das Volumen der Streuungsschicht beträgt, wobei der Absolutwert des Unterschieds zwischen dem Brechungsindex der Partikel, die in der Streuungsschicht enthalten sind, und dem Brechungsindex des thermoplastischen kristallinen Harzes in der Streuungsschicht 0,05 bis 0,90 beträgt, die beiden Oberflächen des mehrschichtigen Films eine Mittellinien-gemittelte Oberflächenrauigkeit Ra von nicht mehr als 30 nm aufweisen und der mehrschichtige Film eine Gesamtlichtdurchlässigkeit Tt wie gemessen nach JIS K6714 von nicht weniger als 80 % und ein Trübungsverhältnis wie gemessen nach JIS K6714 von nicht weniger als 8 % aufweist,
wobei der Brechungsindex des thermoplastischen kristallinen Harzes der Mittelwert des Brechungsindexes nMD in der filmbildenden Richtung innerhalb der Filmebene und des Brechungsindexes nTD in einer Richtung senkrecht auf die filmbildende Richtung innerhalb der Filmebene bei einer Wellenlänge von 633 nm ist,
wobei Vol.-% ein Wert ist, der aus der wahren Dichte der Partikel und der Dichte des Harzes in einem amorphen Zustand berechnet ist, erhalten aus dem Gehalt (Gew.-%) der Partikel in der Streuungsschicht, und
wobei die Mittellinien-gemittelte Oberflächenrauigkeit Ra aus der Gleichung (1)

$$Ra = 1/(LXLY) \int_0^{LX} \int_0^{LY} |f(X, Y)| dXdY \tag{1}$$

berechnet ist, wobei eine Rauigkeitskurve durch Z = F(X, Y) dargestellt und durch Messen eines Projektionsprofils der Oberfläche des Films mit einer optischen Sonde mit einem Strahldurchmesser von 1,6 $\mu$m eines Halbleiterlasers

mit einer Wellenlänge von 780 nm unter Verwendung eines kontaktfreien 3D-Rauigkeitsmessgeräts unter folgenden Bedingungen erhalten ist: Messlänge (LX) 1 mm, Probe-Schrittweite 2 μm, Höchstwert 0,25 mm, Vergrößerung in Längsrichtung 5.000 X, Vergrößerung in Querrichtung 200 X und 100 Abtastungslinien.

**2.** Mehrschichtiger Film für die Verwendung als Solarzellensubstrat gemäß Anspruch 1, wobei die thermoplastischen kristallinen Harze der Trägerschicht und der Streuungsschicht ein thermoplastischer Polyester sind.

**3.** Mehrschichtiger Film für die Verwendung als Solarzellensubstrat gemäß Anspruch 2, wobei der thermoplastische Polyester der Trägerschicht und der Streuungsschicht ein Polyester ist, der eine Ethylen-2,6-naphthalindicarboxylatkomponente als die Hauptwiederholungseinheit umfasst.

**4.** Mehrschichtiger Film für die Verwendung als Solarzellensubstrat gemäß Anspruch 3, wobei die Partikel Siliciumoxidpartikel oder Melaminharzpartikel sind.

**5.** Mehrschichtiger Film für die Verwendung als Solarzellensubstrat gemäß einem der Ansprüche 1 bis 4, wobei der mehrschichtige Film eine dreischichtige Struktur aufweist, die aus einer Trägerschicht, einer Streuungsschicht und einer Trägerschicht in dieser Reihenfolge besteht.

**6.** Verwendung eines mehrschichtigen Films als Substrat für eine Solarzelle, wobei die Solarzelle eine Solarzelle vom Flexibler-Dünnfilm-Typ ist und wobei der mehrschichtige Film wie in einem der Ansprüche 1 bis 4 definiert ist.

## Revendications

**1.** Film multicouche pour utilisation comme un substrat de cellule solaire, composé d'une/de couche(s) de support et d'une/de couche(s) de diffusion, dans lequel
la couche de support comprend une résine thermoplastique cristalline, la couche de diffusion comprend une résine thermoplastique cristalline et des particules ayant un indice de réfraction différent de l'indice de réfraction de la résine thermoplastique cristalline, la teneur des particules dans la couche de diffusion est de 0,05 à 20 % en volume par rapport au volume de la couche de diffusion, la valeur absolue de la différence entre l'indice de réfraction des particules contenues dans la couche de diffusion et l'indice de réfraction de la résine thermoplastique cristalline dans la couche de diffusion est de 0,05 à 0,90, les deux surfaces du film multicouche ont une rugosité de surface moyenne sur la ligne centrale Ra inférieure ou égale à 30 nm, et le film multicouche a un facteur de transmission lumineuse total Tt tel que mesuré conformément à JIS K6714 supérieur ou égal à 80 % et un pourcentage de trouble tel que mesuré conformément à JIS K6714 supérieur ou égal à 8 %,
dans lequel l'indice de réfraction de la résine thermoplastique cristalline est la valeur moyenne de l'indice de réfraction $n_{MD}$ dans la direction de formation de film à l'intérieur du plan du film et de l'indice de réfraction $n_{TD}$ dans une direction perpendiculaire à la direction de formation de film à l'intérieur du plan du film, à une longueur d'onde de 633 nm,
dans lequel le % en volume est une valeur calculée à partir de la densité réelle des particules et de la densité de la résine dans un état amorphe obtenue à partir de la teneur (% en poids) des particules dans la couche de diffusion, et
dans lequel la rugosité de surface moyenne sur la ligne centrale Ra est calculée à partir de l'équation (1)

$$Ra = 1/(LXLY)\int_{0}^{LX}\int_{0}^{LY}|f(X,Y)|\,dXdY \qquad (1)$$

dans lequel une courbe de rugosité est représentée par Z = F(X,Y) et est obtenue en mesurant un profil de projection de la surface du film avec une sonde optique ayant un diamètre de faisceau de 1,6 μm d'un laser à semi-conducteur ayant une longueur d'onde de 780 nm en utilisant un appareil de mesure de rugosité 3-D sans contact dans les conditions suivantes : longueur de mesure (LX) de 1 mm, pas d'échantillonnage de 2 μm, seuil de coupure de 0,25 mm, grossissement dans la direction longitudinale de 5000X, grossissement dans la direction transversale de 200X et 100 lignes de balayage.

**2.** Film multicouche pour utilisation comme un substrat de cellule solaire selon la revendication 1, dans lequel les résines thermoplastiques cristallines de la couche de support et de la couche de diffusion sont un polyester thermoplastique.

**3.** Film multicouche pour utilisation comme un substrat de cellule solaire selon la revendication 2, dans lequel le polyester thermoplastique de la couche de support et de la couche de diffusion est un polyester comprenant un composant dicarboxylate d'éthylène-2,6-naphtalène comme le principal motif récurrent.

**4.** Film multicouche pour utilisation comme un substrat de cellule solaire selon la revendication 3, dans lequel les particules sont des particules de silice ou des particules de résine de mélamine.

**5.** Film multicouche pour utilisation comme un substrat de cellule solaire selon l'une quelconque des revendications 1 à 4, le film multicouche ayant une structure à trois couches composée d'une couche de support, d'une couche de diffusion et d'une couche de support dans cet ordre.

**6.** Utilisation d'un film multicouche comme un substrat pour une cellule solaire, dans laquelle la cellule solaire est une cellule solaire à couches minces de type souple et dans laquelle le film multicouche est tel que défini dans l'une quelconque des revendications 1 à 4.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 1198081 A
- JP 2260577 A
- JP 6005782 B
- JP 6350117 A
- JP 4196364 A
- JP 1119074 A
- JP 3749015 B
- JP 7050794 B
- JP 2000124485 A
- JP 1275031 A